Europäisches Patentamt

European Patent Office

Office européen des brevets

(11) Veröffentlichungsnummer: **0 236 739**
**A1**

(12) **EUROPÄISCHE PATENTANMELDUNG**

(21) Anmeldenummer: 87101542.6

(22) Anmeldetag: 05.02.87

(51) Int. Cl.³: **H 01 L 23/36**
**C 09 J 5/06**

(30) Priorität: 21.02.86 DE 3605692

(43) Veröffentlichungstag der Anmeldung:
16.09.87 Patentblatt 87/38

(84) Benannte Vertragsstaaten:
AT BE CH DE FR GB IT LI NL SE

(71) Anmelder: Siemens Aktiengesellschaft Berlin und München
Wittelsbacherplatz 2
D-8000 München 2(DE)

(72) Erfinder: Prussas, Herbert, Dipl.-Ing.
Mozartring 11
D-8069 Reichertshausen(DE)

(72) Erfinder: Wimmer, Alfred
Fernpassstrasse 40
D-8000 München70(DE)

(54) **Temperaturänderungen ausgesetzte Anordnung.**

(57) Temperaturänderungen ausgesetzte Anordnung mit
— einer erwartbaren oder zulässigen Höchsttemperatur z.B. +150°C,
— einer erwartbaren oder zulässigen Niedrigsttemperatur z.B. −40°C − , so daß zwischen der Höchsttemperatur und der Niedrigsttemperatur eine Grenzdifferenz − von z.B. dann 190°C − besteht,
— Betriebstemperaturen, die ständig oder immer wieder dicht bei der Höchst − und/oder Niedrigsttemperatur liegen,
— zwei festen, nebeneinander liegenden Körpern (1, 2),
   * welche einen deutlich voneinander abweichenden Wärmeausdehnungs-Koeffizienten aufweisen und
   * von welchen einer(1) dieser beiden Körper (1, 2) eine deutlich geringere Bruchfestigkeit als der andere (2) aufweist,
sowie
— einer flächigen Klebverbindung (3) aus unter Erwärmung ausgehärtetem Klebstoff (3), z.B. Zweikomponentenklebstoff (3), zwischen den beiden Körpern (1, 2),
nämlich
— einen Klebstoff,
   welcher, zur Erreichung einer besonders großen Grenzdifferenz ohne Bruchgefahr für den bruchempfindlichen Körper (1), bei einer zumindest angenähert mittleren Temperatur − z.B. bei +90°C − ausgehärtet ist,
welcher nämlich bei einer Temperatur, die mindestens um 18% der Grenzdifferenz − also z.B. um mindestens um rund 35°C − niedriger ist als die Höchsttemperatur, ausgehärtet ist.

FIG 1

EP 0 236 739 A1

Temperaturänderungen ausgesetzte Anordnung.

Die Erfindung betrifft eine Weiterentwicklung der im Oberbegriff des Patentanspruches 1 angegebenen speziellen Anordnung, welche eine flächige Verklebung eines bruchempfindlichen Körpers mit einem relativ bruchunempfindlichen
Körper enthält. Durch gewisse Temperaturen treten sehr hohe
Zug- oder Druckspannungen im bruchempfindlichen Körper auf,
so daß er bei zu starker Temperaturänderung schließlich zu
brechen droht bzw. wirklich bricht. Solche Anordnungen sind
dem Fachmann bekannt, vgl. z.B.
- E-A 48 938.

Es ist ferner dem Fachmann wohlbekannt, daß häufig auch -
unabhängig von der Bruchgefahr für den bruchempfindlichen
einen der beiden Körper - die Klebverbindung zwischen den
beiden Körpern durch die temperaturbedingten Spannungen
platzt und dadurch die Anordnung zerstört wird, vgl. z.B.
- E-A 111 252.

Die Aufgabe der Erfindung ist, die durch Temperaturen bewirkte Bruchgefahr innerhalb des - z.B. für den Betrieb
und/oder für die Lagerung - üblichen Temperaturbereiches
dieser Anordnung zu verringern, oder die Grenzendifferenz
ohne Erhöhung der Bruchgefahr zu vergrößern.

Diese Aufgabe wird im allgemeinen bisher vom Fachmann auf
vier verschiedene Wege gelöst, nämlich dadurch, daß man
- ein anderes Material für zumindest einen der beiden Körper wählt, so
- - daß die Wärmeausdehnungs-Koeffizienten beider Körper
    sich weniger stark voneinander unterscheiden und/oder

- - daß das bruchempfindliche Material durch ein weniger bruchempfindliches ersetzt wird, und/oder

- die Größe der Fläche der Verklebung verringert, um die temperaturbedingten inneren Spannungen im bruchempfindlichen Körper zu verringern, und/oder

- die Form zumindest eines der beiden Körper ändert, z.B. indem man in ihm Dehnungsfugen anbringt, und/oder

- einen anderen, z.B. sehr elastischen Klebstoff verwendet, also z.B. einen Klebstoff, der zumindest im oberen Temperaturbereich sehr elastisch ist.

Die Erfindung löst diese Aufgabe jedoch durch die im Patentanspruch 1 angegebenen Maßnahmen. Die Erfindung zeigt damit einen weiteren, fünften Weg zur Lösung dieser Aufgabe, wobei dieser fünfte Weg für sich allein oder zusätzlich zu einzelnen der, oder zusätzlich zu allen bisherigen vier anderen Wegen gewählt werden kann.

Die in den Unteransprüchen angegebenen zusätzlichen Maßnahmen gestatten, zusätzliche Vorteile zu erreichen. So gestatten u.a. die Maßnahmen gemäß dem Patentanspruch

2, die Anordnung regelmäßig thermisch bis an die äußersten Grenzen zu belasten,

3, die erfindungsgemäße Maßnahme auch auf eine Verklebung einer dünnen bruchempfindlichen Keramikscheibe mit einem stabilen Metallkörper anzuwenden, was besonders heikel ist, weil sich die beiden Materialien hinsichtlich ihrer Bruchfestigkeit und hinsichtlich ihrer Wärmeausdehnungs-Koeffizienten erheblich unterscheiden, sowie

4, die erfindungsgenäße Maßnahme auf die Verklebung bei einer in der Elektrotechnik, besonders bei modernen elektronischen Wählvermittlungssystemen, vielfach verwendeten Anordnung anzuwenden.

001 01 02

0236739

Die Erfindung und ihre Weiterbildungen werden anhand der in den Figuren gezeigten Ausführungsbeispiele weiter erläutert. Dabei zeigt die Figur

1 einen Schnitt durch eine Anordnung, welche dem Patentanspruch 4 entspricht und gemäß der - E-A 48 938 aufgebaut ist, sowie

2 ein Diagramm zur Veranschaulichung der im bruchempfindlichen Körper auftretenden inneren Spannungen, mit und ohne Anwendung der erfindungsgemäßen Maßnahmen.

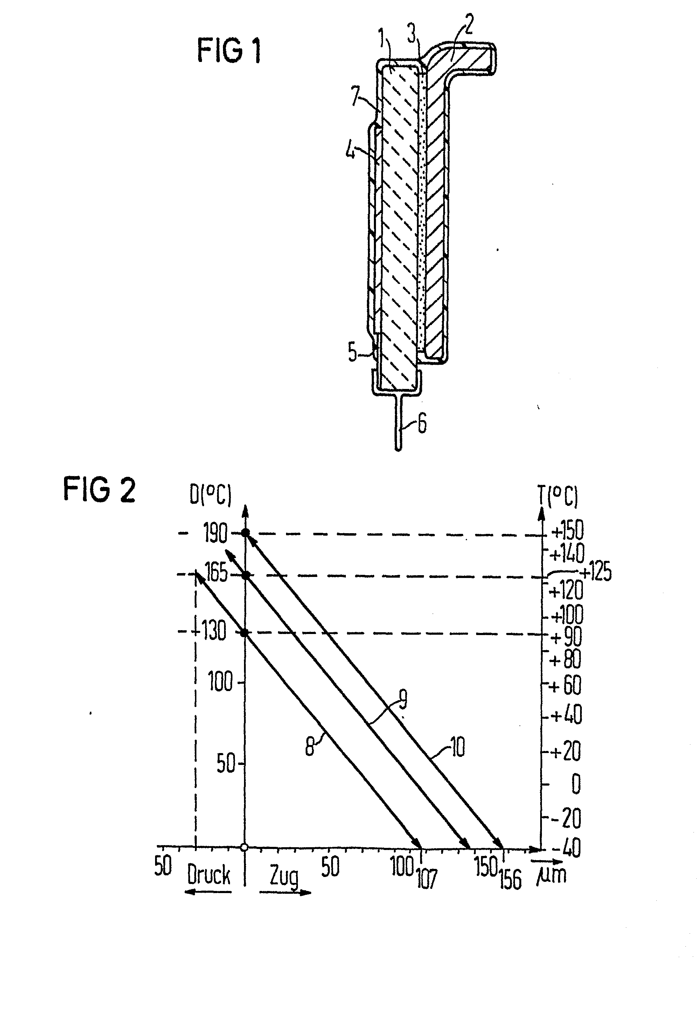

Die Erfindung wurde zunächst für die in Fig. 1 gezeigte Anordnung entwickelt, welche gemäß der

- E-A 48 938

aufgebracht ist und daher einen keramischen dünnen bruchempfindlichen Träger 1 aufweist,

- wobei der keramische Träger 1 elektrische Baukörper trägt, nämlich z.B. Widerstandsschichten 4, welche über aufgedruckte Leitungen 5 mit Single-in-line-Kontaktstiften 6 leitend verbunden sind, und

- wobei dieser Träger 1 mittels eines ausgehärteten Klebstoffes 3 mit einem Aluminium-Kühlblech 2 mit stark abweichendem Wärmeausdehnungs-Koeffizienten verklebt ist.

Die Anordnung kann noch weitgehend mit einem Schutzlack 7 bedeckt sein. Diese bekannte Anordnung wird im Regelfall im Betrieb durch die Verlustwärme ihrer Baukörper

- einerseits maximal +130 °C, in wenigen Überlastungsfällen vielleicht +150 °C heiß,

- andererseits minimal auf z.B. -40 °C abgekühlt, z.B. vor der Anwendung, nämlich noch beim Versand per Post in strengen Wintern mancher Gegenden.

Die Erfindung ist jedoch keineswegs auf diese spezielle Anordnung beschränkt. Sie ist nämlich schlechthin definierbar

001 01 03

als eine zwei miteinander verklebte Körper darstellende Anordnung, die

- eine, warum auch immer, erwartbare oder zulässige Höchsttemperatur (von z.B. +150 °C), und

- eine, warum auch immer, erwartbare oder zulässige stark abweichende Niedrigsttemperatur (von z.B. -40 °C) aufweist,

so daß zwischen der Höchsttemperatur und der Niedrigsttemperatur eine erhebliche Grenzendifferenz (von z.B. dann 190 °C) besteht. Diese zwei festen, nebeneinander liegenden Körper 1, 2 weisen hierbei einen deutlich voneinander abweichenden Wärmeausdehnungs-Koeffizienten auf, wobei überdies der eine Körper 1 (hier die dünne Keramikscheibe 1) eine deutlich geringere Bruchfestigkeit als der andere Körper 2 (hier das Kühlblech 2) aufweist.

Ferner befindet sich eine flächige Klebverbindung 3 aus unter Erwärmung ausgehärtetem Klebstoff 3, z.B. Zweikomponentenklebstoff 3, zwischen den beiden Körpern 1, 2, so daß der bruchempfindliche Körper 1 (hier Keramikscheibe 1) wegen der ganz erheblichen Grenzendifferenz zum Zerspringen neigt. Zur Verminderung dieser Bruchgefahr wird hierbei ein Klebstoff 3 verwendet, welcher bei einer (zumindest angenähert) mittleren Temperatur innerhalb des Bereiches zwischen der Höchst- und der Niedrigsttemperatur ausgehärtet wird (z.B. angenähert in der Mitte zwischen +150 °C ... -40 °C, z.B. also bei +90 °C) - wobei nämlich die Aushärtetemperatur um mindestens 18 % der Grenzendifferenz (hier im Beispiel also mindestens rund 35 °C) niedriger ist als die Höchsttemperatur.

Die optimale Aushärtetemperatur ist im Prinzip verschieden definierbar, z.B. dadurch, daß bei ihr die Bruchwahrscheinlichkeit bei der Höchst- und bei der Niedrigsttemperatur etwa gleich groß, aber jeweils - gerade noch oder mit Si-

**0236739**

cherheit noch - zulässig klein ist. In diesem Fall liegt die optimale Aushärtetemperatur meistens nicht exakt in der Mitte zwischen der Höchst- und der Niedrigsttemperatur. Dies hat mehrere Gründe:

- Die exakte Größe des Wärmeausdehnungs-Koeffizienten jedes der beiden Körper 1, 2 ist meistens mehr oder weniger von der absoluten, jeweiligen Temperatur abhängig. Z.B. kann dieser Koeffizient des betreffenden Körpers 1 und/oder 2 bei der Niedrigsttemperatur viel kleiner als bei der Höchsttemperatur desselben Körpers sein. Daher sind die Zug- und Druckspannungen im bruchempfindlichen Körper sehr oft nichtlinear von der Temperatur abhängig.

- Auch der Klebstoff 3 ist häufig je nach Temperatur, für sich betrachtet, steif oder elastisch, was ebenfalls die optimale Aushärtetemperatur beeinflußt. Wenn, zur Optimierung der Aushärtetemperatur, die Bruchwahrscheinlichkeit (z.B. ca. $10^{-4}$) für den Bruch des bruchempfindlichen Körpers (hier der dünnen Keramikscheibe 1) bei der Höchsttemperatur (+150 °C) etwa gleich groß wie bei der Niedrigsttemperatur (-40 °C) sein soll, weicht daher häufig (auch) wegen der Temperaturabhängigkeit der Elastizität des Klebstoffes 3 die optimale Aushärtetemperatur nach oben oder nach unten von der exakten mittleren Temperatur (+55 °C) ab.

- Überdies ist so mancher bruchempfindlicher Körper 1, z.B. Keramik, zwar sehr empfindlich gegen Zugspannungen, aber wenig empfindlich gegen Druckspannungen. Auch deswegen ist die optimale Aushärtetemperatur, bei der die Bruchwahrscheinlichkeit bei der Höchsttemperatur etwa gleich der Bruchwahrscheinlichkeit bei Niedrigsttemperatur ist, nicht exakt in der Mitte zwischen der Höchst- und der Niedrigsttemperatur.

Die optimale Aushärtetemperatur - unter der Annahme, daß

001 01 05

das Optimum erreicht ist, sobald die Bruchwahrscheinlichkeit bei der Höchsttemperatur etwa gleich die Bruchwahrscheinlichkeit bei der Niedrigsttemperatur ist - ist daher oft nicht ohne weiteres rein theoretisch ermittelbar, sondern oft am leichtesten oder am genauesten durch Versuche.

In sehr vielen Fällen genügt es aber, wenn die Aushärtetemperatur nicht präzise optimal in diesem bisher genannten Sinne gewählt wurde, weil in diesen vielen Fällen die Bruchwahrscheinlichkeit bei der Höchst- und/oder bei der Niedrigsttemperatur ohnehin noch so extrem niedrig ist, also weitaus kleiner als zulässig ist, daß die exakte Optimierung der Aushärtetemperatur gleichzeitig hinsichtlich beider Grenztemperaturen unnötig ist. Es genügt dann, wenn die Aushärtetemperatur grob angenähert jener optimalen Aushärtetemperatur entspricht, weil die Bruchwahrscheinlichkeit trotz unexakter Optimierung der Aushärtetemperatur sowohl bei der Höchsttemperatur als auch bei der Niedrigsttemperatur unter dem zulässigen Wert bleibt, und zwar zumindest an einer dieser beiden Grenztemperaturen dann sogar sehr weit unter dem zulässigen Wert.

In manchen Fällen ist also gar nicht gefordert, daß die Bruchwahrscheinlichkeit bei der Höchsttemperatur etwa gleich groß wie die Bruchwahrscheinlichkeit bei der Niedrigsttemperatur ist. Z.B. gibt es auch Anwendungsfälle der erfindungsgemäßen Anordnung, in welchen - aus irgendeinem Grund - extrem große Folgeschäden nur dann auftreten, falls ein Bruch des Körpers 1 und damit eine Störung des Betriebes des elektrischen Baukörpers 4, also z.B. ein Zerreißen der Widerstandsschicht 4, plötzlich und ohne es vorher (mit dem ökonomisch vertretbaren Aufwand) rechtzeitig bemerken zu können, nur an einer der beiden Grenztemperaturen auftreten würde, - also z.B. ausgerechnet während des thermisch höchstbelasteten Betriebes solcher Anordnungen in einer großen Fernsprechvermittlungsanlage mit z.B. oft mehr als 100 000 solchen Anordnungen, die auch bei Spitzenbelastung der Anlage stets absolut zuverlässig arbeiten sollen. In einem solchen Ausnahmefall kann manchmal die zulässige Bruchwahrscheinlichkeit bei Höchsttemperatur viel kleiner sein als bei der - z.B. nur beim Versand vom Hersteller zum späteren Ort der Anlage - kaum je auftretenden Niedrigsttemperatur, weswegen dann auch deswegen die optimale Aushärtetemperatur - mehr oder weniger stark - von der exakten Mitte zwischen der Höchsttemperatur und der Niedrigsttemperatur abweichen kann.

Daher liegt bei der Erfindung die - wie auch immer definierte - optimale Aushärtetemperatur selten exakt bei der Mitte zwischen der Höchsttemperatur und der Niedrigsttemperatur, sondern meistens bei einem bestimmten Wert abseits nach oben oder unten von dieser Mitte - und zwar häufig auch innerhalb eines noch relativ breiten Temperaturtoleranzbereiches, besonders falls die erreichte Bruchwahrscheinlichkeit bei der Höchsttemperatur und/oder bei der Niedrigsttemperatur sehr viel kleiner als zulässig ist und daher die Optimierung der Aushärtetemperatur nicht exakt eingehalten werden muß.

Dies wird noch präziser anhand des speziellen, in Fig. 1 gezeigten Beispiels der Anordnung erläutert: Eine solche Anordnung, mit - oft sehr hohe Verlustwärme abgebenden - dünnen Widerstandsschichten 4 auf einem bruchempfindlichen keramischen Träger 1 wird z.B. dadurch hergestellt, daß in einer Siebdruckmaschine zuerst der Kühlwinkel 2 auf der Klebeseite ganzflächig mit dem dann noch flüssigen Klebstoff 3 bedruckt und danach in eine Montage-Hilfsvorrichtung mit der Klebefläche nach oben eingelegt wird. Mittels Anschlägen kann nun der mit der Widerstandsschicht 4 beschichtete Träger 1 dem Kühlwinkel 2 genau zugeordnet werden.

001 01 07

Niederhalter-Werkzeuge sorgen für den erforderlichen Druck, um ganzflächig beide Seiten der Körper 1 und 2 mit Klebstoff 3 zu benetzen, und halten beide Körper 1 und 2 während der Aushärtung des Klebstoffes 3 in der vorgeschriebenen Lage.

Die Aushärtung des Klebstoffes 3 wurde, um eine hohe Festigkeit des Klebstoffes 3 zu erreichen, wie zunächst abweichend vom erfindungsgemäßen Konzept üblich, bei der zulässigen Betriebs-Höchsttemperatur der Anordnung, nämlich bei +125 °C, +130 °C oder bei +150 °C durchgeführt. Normalerweise war hierbei die Quote für Ausschuß durch Bruch des Trägers 1 sehr klein. Ohne einen auch nach mehreren Untersuchungen nicht zuverlässig festgestellten Grund traten jedoch manchmal später auffällig viele Brüche des dünnen keramischen Trägers 2 auf, die dann oft weit über 10 % aller Anordnungen betrafen. Besonders unangenehm waren Spätausfälle, wenn nämlich solche Brüche erst nach dem Postversand und nach der Montage in einem Fernsprech-Vermittlungssystem auftraten und dann starke, unerwartete Funktionsstörungen des Vermittlungssystemes bewirkten. Die starken Temperaturschwankungen und die dadurch bewirkten Brüche waren zunächst nur eine der vielen in Betracht zu ziehenden Ursachen. Auch durch Temperaturschocken aller ausgehärteten Anordnungen vor dem Postversand konnten solche Spätausfälle nicht völlig vermieden werden, weswegen schließlich sogar erwogen wurde, die Produktion dieser Anordnungen völlig zu stoppen, um die Anordnung nach den oben genannten vier Wegen neu zu entwickeln.

Genaue wissenschaftliche Untersuchungen zeigten jedoch folgendes Ergebnis:

Die Fig. 2 zeigt Diagramme für die Temperaturabhängigkeit (Ordinate) der Differenz der Ländenausdehnungen (Abszisse) des hier 50 mm langen keramischen Trägers 1 und des gleich langen Aluminium-Kühlwinkels 2 unter der Annahme, daß
- beide Körper 1, 2 noch nicht verklebt sind und
- die Längenausdehnungen linear von der Temperatur abhängen würden.

Auf der rechten Ordinate sind die absoluten Temperaturwerte T und auf der linken Ordinate die relativen Temperaturwerte D, bezogen auf die Niedrigsttemperatur -40 °C, angegeben.

Die Kurve 10 entspricht dann angenähert einer Anordnung, die bei +150 °C ausgehärtet wurde, die Kurve 9 entspricht derselben Anordnung mit +125 °C Aushärtetemperatur, und die Kurve 8 derselben Anordnung mit +90 °C Aushärtetemperatur.

Während der Aushärtung des Klebstoffes 3 sind nämlich sowohl der Träger 1 als auch der Aluminium-Kühlwinkel 2 de facto frei von inneren mechanischen Spannungen, abgesehen von hier vernachlässigbaren, durch Materialinhomogenitäten des Trägers 1 bedingten inneren Spannungen im Träger 1, vgl. die Kurven 8, 9 und 10 für 0 μm Längenausdehnungsdifferenz. Sobald jedoch nach dem Aushärten des Klebstoffes 3 die Abkühlung beginnt, treten unterschiedliche Längenänderungen zwischen dem keramischen Träger 1 und dem Aluminium-Kühlwinkel 2 auf, vgl. wieder die Kurven 8, 9 und 10. Im Test wurden die Anordnungen Niedrigsttemperaturen bis zu -40 °C ausgesetzt, wodurch alle diese Anordnungen einer maximalen Temperaturdifferenz D bis zu 190 °C ausgesetzt wurden, vgl. die Kurve 10. Für den 50 mm langen Träger 1 bewirkt diese 190 °C-Temperaturdifferenz D an sich, d.h. ohne ausgehärtete Verklebung, eine Längenänderung von 67 μm, für den 50 mm langen Aluminium-Kühlwinkel 2 aber an sich eine um das 3,3-fache größere Längenänderung, nämlich von 223 μm. Die Differenz dieser Längenänderungen beträgt dann 156 μm, vgl. wieder Fig. 2. Dadurch wirkt die ausgehärtet verklebte Anordnung wie ein Bimetall und krümmt sich in der Weise, daß im Träger 1 Zugspannungen und im Aluminium-Kühlwinkel 2 Druckspannungen auftreten, solange die Anordnung heißer ist als die Aushärtetemperatur, aber im Träger 1 Druckspannungen und im Aluminium-Kühlwinkel 2 Zugspannungen, solange die Anordnung kälter ist als die Aushärtetemperatur, vgl. die Kurven 8, 9 und 10. Vor allem die Zugspannungen im Träger 1 können sofort oder auch erst nach Wochen Risse im Träger 1 hervorrufen, welche den Funktionsausfall der von ihm getragenen Widerstandsschicht 4 bewirken können.

Das Konzept der erfindungsgemäßen Problemlösung liegt darin, die bis dahin bei Abkühlung von +150 °C auf -40 °C entsprechend Kurve 10 von Null auf einen hohen Maximalwert anschwellende Druckbeanspruchung des Trägers 1 in eine Zug-/Druck-Wechselbeanspruchung des Trägers 1 umzuwandeln, die einen zulässigen, d.h. ausreichend niedrigen Maximalwert für die Druckspannung bei der Niedrigsttemperatur, z.B. -40 °C, und einen zulässigen, d.h. ausreichend niedrigen Maximalwert für die Zugspannung im Träger 1 bei der Höchsttemperatur, z.B. +150 °C, der Anordnung aufweist. Dieses Konzept der Erfindung ließ sich durch Senken der Aushärtetemperatur verwirklichen, z.B. im vorliegenden Fall durch Aushärtung bei +90 °C gemäß der Kurve 8, wonach die Wärmeausdehnungen beider Körper 1, 2 dann theoretisch an sich nur noch maximal um 107 μm, also um etwa 30 % weniger als vorher differieren. Die notwendige Dauer für die Aushärtung des Klebstoffes 3 war zwar größer als bei viel höherer Aushärtetemperatur, die notwenige Dauer bei der niedrigen Aushärtetemperatur war aber noch ertragbar.

Die inneren Spannungen in der Anordnung sinken also durch diese Aushärtung des Klebstoffes 3 bei angenähert mittlerer Temperatur auf unkritische Werte, und Risse in der Keramik des Trägers 1 wurden experimentell im Labor und danach in der Fertigung seit der Einführung der gesenkten Aushärtetemperatur nicht mehr festgestellt. Bei den gemäß der Kurve 9 ausgehärteten Anordnungen wurden hingegen gelegentlich, wenn auch selten, noch Brüche im Träger 1 festgestellt. Daher war es bei dieser Anordnung seit der Anwendung der erfindungsgemäßen Maßnahmen gemäß der Kurve 8 sogar völlig unnötig, nun zusätzlich noch irgendeinen der anderen vier bekannten, oben genannten Wege zur Beherrschung dieses Problemes zu benützen.

An der fertig hergestellten Anordnung kann man auch noch nach der Aushärtung nachträglich die Aushärtetemperatur im allgemeinen z.B. bereits dadurch ausreichend genau feststellen,
- indem man künstlich, z.B. durch einen starken Kälteschock, den bruchempfindlichen Körper 1 zerbricht und
- indem man anschließend unter dem Mikroskop bei kontinuierlicher Erwärmung oder Abkühlung jene Temperatur bestimmt, bei welcher sich der Bruchspalt schließt.
Jene Temperatur, bei der sich der Bruchspalt schließt, entspricht ziemlich genau der Aushärtetemperatur.

4 Patentansprüche,
2 Figuren

0236739

VPA 86 P 1073 E

Bezugszeichenliste

| | |
|---|---|
| 1 | Körper (keramischer Träger) |
| 2 | Körper (Aluminium-Winkel) |
| 3 | Klebstoff |
| 4 | elektrischer Baukörper (Widerstandsschicht) |
| 5 | Zuleitung |
| 6 | Kontaktstift |
| 7 | Schutzlack |
| 8 | Kurve für +90 °C Aushärtetemperatur |
| 9 | Kurve für +125 °C Aushärtetemperatur |
| 10 | Kurve für +150 °C Aushärtetemperatur |

001 01 15

Patentansprüche

1. Temperaturänderungen ausgesetzte Anordnung mit
- einer erwartbaren oder zulässigen Höchsttemperatur - z.B. +150 °C - als der einen Grenztemperatur,
- einer erwartbaren oder zulässigen Niedrigsttemperatur - z.B. -40 °C - als der anderen Grenztemperatur, so daß zwischen der Höchsttemperatur und der Niedrigsttemperatur eine Grenzendifferenz - von z.B. dann 190 °C - besteht,
- Betriebstemperaturen, die ständig oder immer wieder dicht bei zumindest einer der beiden Grenztemperaturen, also dicht bei der Höchsttemperatur und/oder dicht bei der Niedrigsttemperatur liegen - also z.B. dicht unter +150 °C - ,
- zwei festen, nebeneinander liegenden Körpern(1, 2),
- - welche einen deutlich voneinander abweichenden Wärmeausdehnungs-Koeffizienten aufweisen und
- - von welchen einer(1) dieser beiden Körper(1, 2) eine deutlich geringere Bruchfestigkeit als der andere(2) aufweist,
sowie
- einer flächigen Klebverbindung(3) aus unter Erwärmung ausgehärtetem Klebstoff(3), z.B. Zweikomponentenklebstoff(3), zwischen den beiden Körpern(1, 2),
g e k e n n z e i c h n e t   d u r c h
- einen Klebstoff,
- - welcher, zur Erreichung einer besonders großen Grenzendifferenz ohne Bruchgefahr für den bruchempfindlichen Körper(1), bei einer zumindest angenähert mitleren Temperatur - z.B. bei +85 °C $\pm$10 °C, also z.B. bei +90 °C - ausgehärtet ist,
- - und zwar bei einer Temperatur, die mindestens um 18 % der Grenzendifferenz - also z.B. mindestens um rund 35 °C - niedriger ist als die Höchsttemperatur.

001 01 12

2. Anordnung nach Patentanspruch 1,
g e k e n n z e i c h n e t   d u r c h

- Grenztemperaturen - also z.B. +150 °C und -40 °C - , bei denen die Bruckwahrscheinlichkeit des die geringere Bruchfestigkeit aufweisenden Körpers(1) jeweils denselben Wert besitzt.


3. Anordnung nach Patentanspruch 1 oder 2,
d a d u r c h   g e k e n n z e i c h n e t ,   daß

- eine dünne, eine relativ geringe Bruchfestigkeit aufweisende Keramikscheibe(1) als den einen Körper(1), und
- einen relativ bruchfesten Metallkörper(2) als den anderen Körper(2).


4. Anordnung nach Patentanspruch 3,
g e k e n n z e i c h n e t   d u r c h

- mindestens eine einzige, im Betrieb hohe Verlustwärmemengen erzeugende elektrische Widerstandsschicht(4) auf der der Klebverbindung(3) abgewandten Seite der Keramikscheibe(1), und
- ein steifes Kühlblech(2) als Metallkörper(2).

001 01 13

0236739

1/1

FIG 1

FIG 2

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int. Cl.4) |
|---|---|---|---|
| A,D | EP-A-0 048 938 (SIEMENS) <br> * Seite 10, Zeile 6 - Seite 11, Zeile 5 * <br><br> --- | 1 | H 01 L 23/36 <br> C 09 J 5/06 |
| A | EP-A-0 111 252 (COMPAKTA-WERKE BAUSTOFF) <br> * Seite 3, Zeilen 10-25; Ansprüche 1,3,5,13 * <br><br> --- | 1 | |
| A | MICROELECTRONICS AND RELIABILITY, Band 16, Nr. 4, 1977, Seiten 303-307, Pergamon Press, Oxford, GB; K.B. DOYLE: "Some experiences and conclusions using soldered and welded packages for hermetic thick film hybrids" <br> * Seite 306, Abschnitt 7 * <br><br> ----- | 1 | RECHERCHIERTE SACHGEBIETE (Int. Cl.4) <br><br> H 01 L <br> C 09 J |

Der vorliegende Recherchenbericht wurde für alle Patentansprüche erstellt.

| Recherchenort <br> DEN HAAG | Abschlußdatum der Recherche <br> 16-06-1987 | Prüfer <br> TOUSSAINT F.M.A. |
|---|---|---|